# EUROPEAN PATENT APPLICATION

(11) **EP 4 738 333 A1**
(43) Date of publication of application: **06.05.2026**
(21) Application number: 25198384.7
(22) Date of filing: 27.08.2025
(51) Int. Cl.: G09G 3/3233

(54) **DISPLAY DEVICE**

(30) Priority: 31.10.2024 KR 20240152994
(71) Applicant: LG Display Co., Ltd., Seoul, 07336 (KR)
(72) Inventor: AHN, Soonsung, Paju-si, Gyeonggi-do, 10845 (KR); KIM, Yangwan, Paju-si, Gyeonggi-do, 10845 (KR)
(74) Representative: Viering, Jentschura & Partner mbB Patent- und Rechtsanwälte

(57) **Abstract**

Disclosed is a display device (1), including: a display panel (50) including a display region (AA) in which pixels (PX) are disposed and a non-display region (NA) disposed around the display region (AA); and at least one gate driver (20) configured to apply a scan signal and a light emission signal to the pixels (PX). A compensation capacitor (C2) is shorted during a light emission period (I5) but receives a direct current voltage during at least one other driving period.

## Description

### CROSS REFERENCE TO RELATED APPLICATION

The present application claims priority to Republic of Korea Patent Application No. 10-2024-0152994 filed on October 31, 2024.

### FIELD

The present disclosure is to improve a flicker performance and reliability of a display panel.

### BACKGROUND

An electroluminescent display is classified into an inorganic electroluminescent display and an organic electroluminescent display depending on a material of an emission layer. An active matrix organic light emitting diode (OLED) display includes OLEDs (organic light emitting diode) capable of emitting light by themselves and has many advantages including fast response time, high emission efficiency, high luminance, wide viewing angle, and the like. In the organic electroluminescent display, an OLED is formed in each of the pixels. The organic electroluminescent display device has not only the fast response time, high emission efficiency, high luminance, a wide viewing angle, and the like, but also an excellent contrast ratio and color reproductivity because the black scale can be expressed in a full black color.

The pixels of the organic electroluminescent display device include a driving element for driving the OLED and a pixel circuit that includes a capacitor connected to the driving element.

There may be a difference in the electric characteristic of the driving element across pixels because of a process deviation and a device characteristic deviation caused during a manufacturing process. Such a difference may increase even more as the driving time passes by. To compensate for a difference in the electric characteristic of the driving element in the pixels, an internal compensation circuit may be added to the pixel circuit. The internal compensation circuit may sample a threshold voltage of the driving element and compensate for a gate voltage of the driving element by as much as the threshold voltage of the driving element. However, when the pixels driven by the internal compensation circuit are operated at low luminance, non-uniform luminance may be caused inside a screen of a display panel.

### SUMMARY

An object of the present disclosure is to compensate for a threshold voltage of the driving element in real-time using the internal compensation circuit and to improve a uniformity of the luminance of the screen. Various embodiments of the present disclosure provide a display device according to claim 1. Further embodiments are described in the dependent claims.

One embodiment is a display device, including: a display panel including a display region and a non-display region around the display region, the display region including pixels; and a data driver configured to apply a data voltage to the pixels; and at least one gate driver configured to apply a scan signal and a light emission signal to the pixels.

At least one of the pixels may include: a light emitting diode including an anode electrode, a cathode electrode, and a light emitting layer between the anode electrode and the cathode electrode; a driving transistor having a first electrode connected to a third node, a gate electrode connected to a second node, and a second electrode connected to a first node; a switching transistor having a first electrode connected to a data line and a second electrode connected to the gate electrode of the driving transistor at the second node, the switching transistor having a gate electrode that receives a first scan signal; a first initialization transistor having a first electrode connected to a reference voltage line and a second electrode connected to the second electrode of the switching transistor and the gate electrode of the driving transistor at the second node, the first initialization transistor having a gate electrode that receives a second scan signal; a first light emission transistor having a first electrode connected to a high potential driving voltage line and a second electrode connected to the first electrode of the driving transistor at the third node, the first light emission transistor having a gate electrode that receives a first light emission signal; a second light emission transistor having a first electrode connected to the second electrode of the driving transistor at the first node and a second electrode connected to the anode electrode of the light emitting diode at a fourth node, the second light emission transistor having a gate electrode that receives a second light emission signal; a first capacitor having a first electrode connected to the second electrode of the switching transistor, the second electrode of the first initialization transistor, and the gate electrode of the driving transistor at the second node and a second electrode connected to the second electrode of the driving transistor and the first electrode of the second light emission transistor at the first node; and a second capacitor having a first electrode connected to the second electrode of the first capacitor, the second electrode of the driving transistor, and the first electrode of the second light emission transistor at the first node and a second electrode connected to the second electrode of the second light emission transistor and the anode electrode of the light emitting diode at the fourth node, wherein the driving transistor includes an oxide semiconductor layer.

In one embodiment, a pixel of a display device comprises: a light emitting diode including an anode electrode, a cathode electrode, and a light emitting layer between the anode electrode and the cathode electrode; a driving transistor having a first electrode connected to a third node, a gate electrode connected to a second node, and a second electrode connected to a first node; a switching transistor having a first electrode connected to a data line and a second electrode connected to the gate electrode of the driving transistor at the second node, the switching transistor having a gate electrode that receives a first scan signal; a light emission transistor having a first electrode connected to the second electrode of the driving transistor at the first node and a second electrode connected to anode electrode of the light emitting diode at a fourth node, the light emission transistor having a gate electrode that receives a light emission signal; a first capacitor having a first electrode connected to the second electrode of the switching transistor and the gate electrode of the driving transistor at the second node and a second electrode connected to the second electrode of the driving transistor and the first electrode of the light emission transistor at the first node; and a second capacitor having a first electrode connected to the second electrode of the first capacitor, the second electrode of the driving transistor, and the first electrode of the light emission transistor at the first node and a second electrode connected to the second electrode of the light emission transistor and the anode electrode of the light emitting diode at the fourth node, wherein the pixel is driven during a plurality of periods including a light emission period during which the first electrode and the second electrode of the second capacitor are short circuited while the light emission transistor is turned on during the light emission period, and during at least another one of the plurality of periods a direct current voltage is applied to the second electrode of the second capacitor while the light emission transistor is turned off.

The technical problem to be achieved by the present disclosure is not limited to the above-mentioned technical problem, and other technical problems that are not mentioned will be clearly understood by ordinary-skilled persons in the art to which the present disclosure pertains from the following description.

The display device according to an embodiment of the present disclosure may accurately compensate for a threshold voltage of the driving element and improve the luminance uniformity in the entire screen when operating the pixels of the display panel at a fast velocity because a sensing step at which a threshold voltage of the driving element is sensed and a writing step at which the pixel data is written into the pixels are divided in terms of the time so that a threshold voltage sensing time can be sufficiently secured. Such an approach may prevent an error component charged at a major node of the pixel circuit by separating a capacitor in which a threshold voltage of the driving element is stored and a capacitor in which a data voltage is stored.

In addition, by setting an anode reset voltage additionally apart from the reference voltage, it is possible to minimize or at least reduce a luminance difference among pixels when a driving frequency of the pixels is changed as a refresh rate is varied, and to improve a flicker phenomenon when a variable driving frequency is applied while using a fewer number of gate lines, thereby improving the image quality.

The effects of the present disclosure are not limited to the above-described effects and other effects which are not described herein may be derived by those skilled in the art from the following description of the embodiments of the present disclosure.

### BRIEF DESCRIPTION OF THE DRAWINGS

FIG. 1 is a block diagram schematically illustrating a display device according to an embodiment of the present disclosure.
FIG. 2 is a cross-sectional view illustrating a lamination shape of a display device according to an embodiment of the present disclosure.
FIG. 3 is a view illustrating a configuration of a gate driver in a display device according to an embodiment of the present disclosure.
FIG. 4 is a view illustrating a pixel circuit in a display device according to an embodiment of the present disclosure.
FIG. 5 is an operation timing chart of a pixel circuit in a display device illustrated in FIG. 4 according to an embodiment of the present disclosure.
FIGS. 6A to 6E are diagrams illustrating operations of a pixel circuit in each operation period in greater detail according to an embodiment of the present disclosure.
FIGS. 7A and 7B are respectively a diagram of a pixel circuit in a display device according to another embodiment of the present disclosure and an operation timing chart of the pixel circuit in that display device.

### DETAILED DESCRIPTION

The merits and characteristics of the present disclosure and a method for achieving the merits and characteristics will become more apparent from the embodiments described in detail in conjunction with the accompanying drawings. However, the present disclosure is not limited to the disclosed embodiments, but may be implemented in various different ways. These embodiments are provided so that this disclosure will be thorough and complete, and will fully convey the scope of the present disclosure to those skilled in the art. The present disclosure will be defined only by the scope of the appended claims. Like reference numerals generally denote like elements throughout the specification.

It will be understood that when an element is referred to as being "connected" or "coupled" to another element, it may be directly connected or coupled to the other element or intervening elements may be present. In contrast, when an element is referred to as being "directly connected" or "directly coupled" to another element, there are no intervening elements present. As used herein, the term "and/or" includes any and all combinations of one or more of the associated listed items.

The terms used in the present specification are merely used to describe specific embodiments and are not intended to limit the present disclosure. A singular expression includes a plural expression unless a description to the contrary is specifically pointed out in context. The terms "comprises" and/or "comprising," when used herein, specify the presence of stated elements, steps, operations, and/or components, but do not preclude the presence or addition of one or more other elements, steps, operations, and/or components.

Although the terms including an ordinal number such as first, second, etc. may be used for describing various elements, the structural elements are not restricted by the terms. The terms are only used to distinguish one element from another element.

Therefore, a first component to be mentioned below may be a second component in a technical concept of the present disclosure. Unless otherwise defined, all terms including technical and scientific terms used herein have the same meaning as commonly understood by one of ordinary skill in the art to which this disclosure belongs. It will be further understood that terms, such as those defined in commonly used dictionaries, will not be interpreted in an idealized or overly formal sense unless expressly so defined herein.

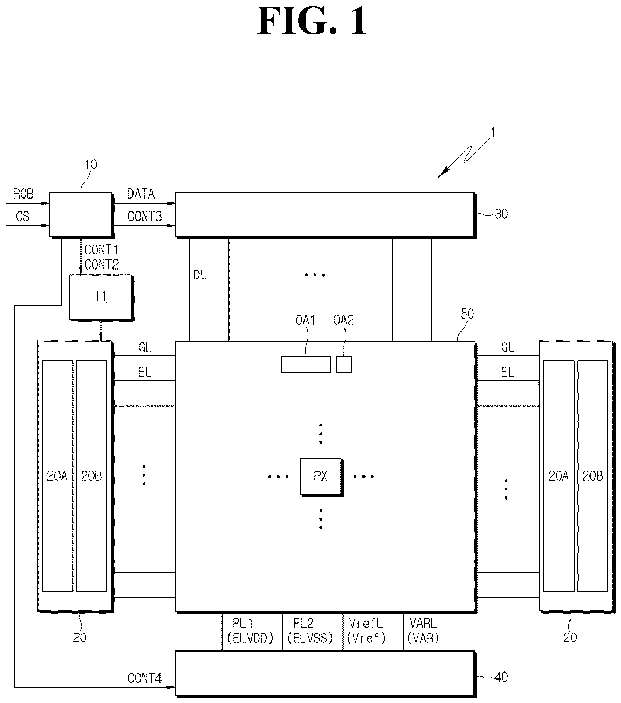

FIG. 1 is a block diagram schematically illustrating a display device according to an embodiment of the present disclosure.

Referring to FIG. 1, the display device 1 includes a timing controller 10, a level shifter 11, a gate driver 20, a data driver 30, a power supply unit 40 (e.g., a circuit), and a display panel 50.

The timing controller 10 may receive a video signal RGB and a control signal CS from an external host system and the like. The video signal RGB may include a plurality of grayscale data. The control signal CS may include, for example, a horizontal synchronization signal, a vertical synchronization signal and a main clock signal.

The timing controller 10 processes the video signal RGB and the control signal CS to be suitable to operational conditions of the display panel 50, and may generate and output image data DATA, a gate driving control signal CONT1, a light emission driving control signal CONT2, a data driving control signal CONT3, and a power supply control signal CONT4.

The level shifter 11 may output a start signal, a clock signal (for example, a gate clock signal), and the like to the gate driver 20 based on the gate driving control signal CONT1, and the light emission driving control signal CONT2 input from the timing controller 10.

The gate driver 20 may include a scan driving circuit 20A configured to generate scan signals based on a gate high voltage VGH and/or a gate low voltage VGL, and signals output from the level shifter 11. The scan driving circuit 20A may provide the generated scan signals to the pixels PX through a plurality of scan lines GL. In an embodiment, one pixel PX may be configured to receive a plurality of scan signals having different waveforms. In such an embodiment, the scan driving circuit 20A may provide the plurality of scan signals to the pixels PX through the scan lines GL corresponding thereto, respectively.

The gate driver 20 may further include a light emission driving circuit 20B configured to generate light emission signals based on signals output from the level shifter 11. The light emission driving circuit 20B may provide the generated light emission signals to the pixels PX through light emission lines EL.

The gate driver 20 may be configured in a Gate-In-Panel form in which the gate driver 20 is mounted on the display panel 50. The gate driver 20 may be disposed on one side of the display panel 50, or on both sides (for example, left and right sides) of the display panel 50 as illustrated. According to a driving method, a panel design manner, and the like, the gate driver 20 may be disposed on both sides (for example, left and right sides) of the display panel 50, or may be connected to two or more side surfaces among four side surfaces of the display panel 50.

The data driver 30 may generate data signals based on the data driving control signal CONT3 and image data DATA output from the timing controller 10. The data driver 30 may provide the generated data signals to the pixels PX through a plurality of data lines DL.

The data driver 30 may be configured with one or a plurality of integrated circuits (IC) to be disposed on one side of the display panel 50. A demultiplexer array (not illustrated) disposed between the data driver 30 and the data lines DL may be further included in the embodiment.

The demultiplexer array sequentially supplies data voltages output from channels of the data driver 30 to the data lines DL by using a plurality of demultiplexers (DEMUX). The demultiplexer may include a plurality of transistors disposed on the display panel 50. When the demultiplexer is disposed between output terminals of the data driver 30 and the data lines DL, a quantity of channels of the data driver 30 may decrease. The demultiplexer array may be omitted.

The timing controller 10 and the data driver 30 may be integrated into one integrated circuit in a mobile device or a wearable device.

The power supply unit 40 may generate a high potential driving voltage ELVDD and a low potential driving voltage EL VSS that is less than the high potential driving voltage ELVDD to be provided to the display panel 50 based on the power supply control signal CONT4. The power supply unit 40 may provide the generated driving voltages ELVDD and EL VSS to the pixels PX through corresponding high and low potential driving voltage lines PL1 and PL2. In addition, the power supply unit 40 may further generate a reference voltage Vref and/or a bias voltage VAR required for driving the pixel PX and may respectively provide the voltage to the pixels PX through a corresponding voltage line VrefL and VARL.

On the display panel 50, a plurality of pixels PX (or referred to as sub-pixels) are disposed. The pixels PX may be disposed, for example, in a matrix form on the display panel 50. The pixels disposed in one pixel row are connected to the same scan line GL and the same light emission line EL, and the pixels disposed in one pixel column are connected to the same data line DL. The pixels PX may emit light at luminance corresponding to a scan signal and a data signal supplied through the scan line GL and the data line DL in response to a light emission signal applied through the light emission line EL.

In addition, each of the pixels PX includes a light emitting diode LD and a pixel circuit configured to control an operation of the light emission diode LD. Here, the light emission diode LD comprises an anode electrode 171, a cathode electrode 173, and a light emission layer 172 between the anode electrode 171 and the cathode electrode 173. Each of pixels PX includes the pixel circuit.

In an embodiment, each pixel PX may display one color among red, green and blue. In another embodiment, each pixel PX may display one color among cyan, magenta and yellow. In various embodiments, each pixel PX may display one color among red, green, blue and white.

The pixels may be disposed as a real color pixel, and a pentile pixel. The pentile pixel may implement a higher resolution than a resolution of the real color pixel by driving two sub-pixels, each of which having a different color, as one pixel PX using a predetermined pixel rendering algorithm. The pixel rendering algorithm may compensate for a color expression lacked in each pixel using a color of light emitted from a neighboring pixel.

The display panel 50 may be implemented as a transmissive or a non-transmissive display panel. The transmissive display panel may be applied to a transparent display device in which an image is displayed in the screen and a real background object that is external to the display panel 50 is visible. The display panel 50 may be manufactured as a flexible display panel. The flexible display panel may be implemented as an OLED panel which uses a plastic substrate.

Touch sensors may be disposed on the display panel 50. A touch input may be sensed using additional touch sensors or may be sensed through pixels PX. The touch sensors may be disposed on the screen of the display panel in an on-cell type or an add-on type or may be implemented as in-cell type touch sensors embedded to the display panel 50.

The display device 1 may further include a touch sensor driver (not illustrated) for driving the touch sensors. The data driver 30 and the touch sensor driver may be integrated in one drive IC (integrated circuit), or each of the data driver 30 and the touch sensor driver may be configured separately.

In an embodiment, one or more optical regions OA1 and OA2 may be disposed on the display panel 50. The one or more optical regions OA1 and OA2 may be disposed by overlapping one or more optical electronic device such as a photographing device such as a camera (an image sensor), and a detection sensor such as a proximity sensor and an illuminance sensor.

For the operation of the optical electronic device, the one or more optical regions OA1 and OA2 have a light transmission structure and have a transmittance of a certain level or higher. The light transmission structure may be configured by patterning the cathode electrode in a portion in which the pixel PX is not disposed. The cathode electrode may be patterned through removal using a laser, or by selectively forming the cathode electrode through a cathode deposition preventing layer.

Alternatively, the light transmission structure may be configured by separating the light emitting diode from the inside the pixel PX. In such an embodiment, the light emitting diode of the pixel PX may be disposed in the optical region OA1 and OA2, the plurality of transistors configuring the pixel PX may be disposed around the optical region OA1 and OA2, and the light emitting diode and the pixel may be electrically connected through a transparent metal layer.

A quantity of the pixels PX per unit area in one or more optical regions OA1 and OA2 may be smaller than a quantity of the pixels PX per unit area in the remaining other region except the optical region OA1 and OA2. That is, resolution of the one or more optical regions OA1 and OA2 may be lower than the resolution of the remaining other region.

In an embodiment, the display device 1 according to an embodiment of the present disclosure may operate in a variable refresh rate mode in which a driving frequency variation is possible. For example, the display device 1 may operate in a refresh rate higher or lower than a predetermined reference refresh rate. The driving of the display device 1 at a refresh rate lower than the reference refresh rate may be referred to as 'low-speed driving' (e.g., a first mode), and the driving of the display device 1 at a refresh rate higher than the reference refresh rate may be referred to as 'high-speed driving' (e.g., a second mode). The refresh rate may be determined according to kinds of displayed images and the like, but is not limited thereto.

The timing controller 10 may generate control signals CONT1 to CONT4 so that the pixel PX can operate at various refresh rates. For example, the timing controller 10 may vary the refresh rate by changing a frequency of a clock signal included in the control signals CONT1 to CONT4 or adjusting a timing of the horizontal synchronization signal or the vertical synchronization signal, or driving the gate driver 20 in a mask manner.

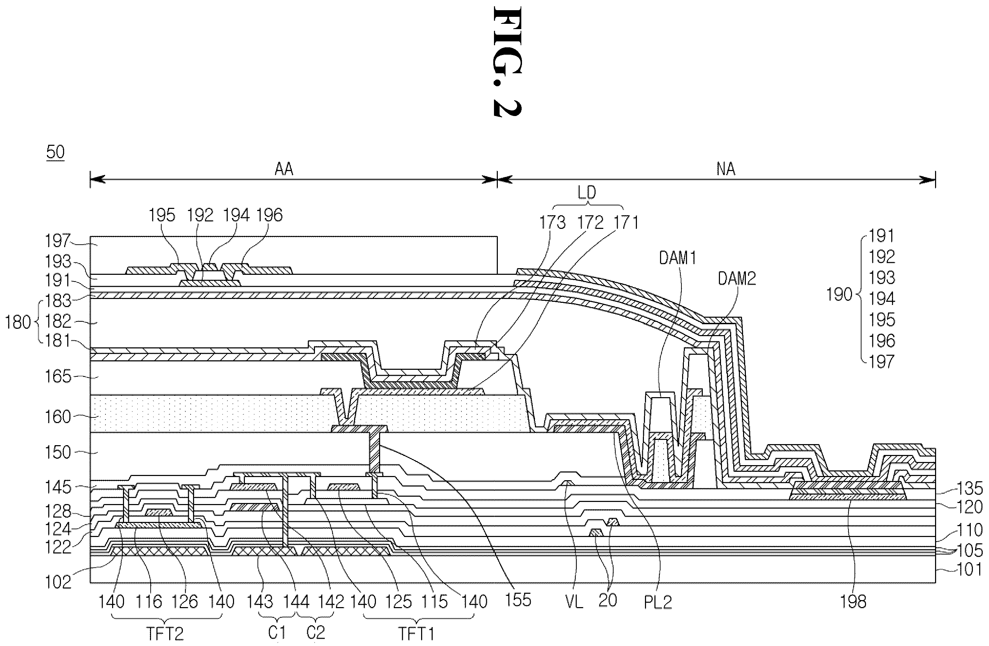

FIG. 2 is a cross-sectional view illustrating a lamination shape of the display device according to an embodiment of the present disclosure.

Referring to FIG. 2, the display panel 50 may include a display region AA in which the pixel PX is positioned, and a non-display region NA disposed around the display region AA and in which the gate driver 20 and the data driver 30 are disposed. The display panel 50 includes a substrate 101, thin film transistors TFT1 and TFT2, a bank layer 165, a light emitting diode LD, an encapsulation layer 180, a touch layer 190, a touch protection layer 197, a dam (e.g., dams DAM1 and DAM2), and a pad part 198.

The substrate 101 supports various components of the display panel 50. The substrate 101 may be formed of a transparent insulation material such as glass, plastic, and the like. When the substrate 101 is formed of plastic, the substrate 101 may be referred to as a plastic film or a plastic substrate. For example, the substrate 101 may be in a film form which includes one among polyimide polymer, polyester polymer, silicon polymer, acrylic polymer, polyolefin polymer, and a copolymer thereof, but the embodiments of the present disclosure are not limited thereto. Also, when the substrate 101 is made of plastic, the substrate 101 may be formed in a dual structure. For example, the substrate 101 may have a dual structure having an adhesive layer interposed between a first polyimide layer and a second polyimide layer.

When the substrate 101 is made of glass, the substrate 101 may be referred to as a glass substrate. For example, the glass substrate may include a shielding metal 102 below the thin film transistor TFT1 and TFT2 and may serve to protect the device from external light or signal interference. Thus, the shielding metal 102 may overlap at least the thin film transistor TFT1 which is a driving transistor, for example.

The thin film transistor TFT1 and TFT2 for driving the light emitting diode LD may be disposed on the substrate 101 in the display region AA. The thin film transistor TFT1 and TFT2 drive the light emitting diode LD in the display region AA.

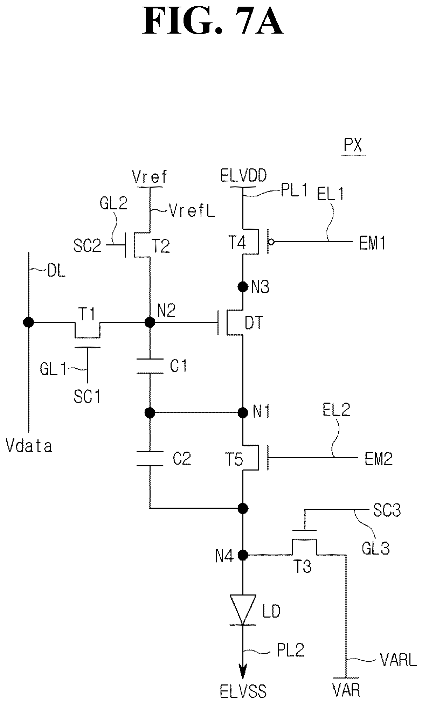

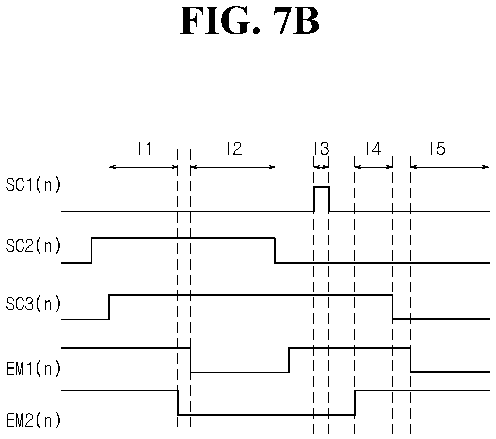

For convenience of description, one thin film transistor TFT1 (for example, a driving transistor DT, FIG. 7) and one thin film transistor TFT2 (for example, a fourth transistor T4, FIG. 7) among various thin film transistors which may be included in the display device 1 are illustrated in FIG. 2, however, the thin film transistors TFT1 and TFT2 are not limited thereto. Hereinafter, an example in which the thin film transistor has a coplanar structure is described, however, the thin film transistors TFT1 and TFT2 may be implemented to have a different structure such as a staggered structure and the like, and is not limited thereto.

The second thin film transistor TFT2 may include a semiconductor layer 116, a gate electrode 126, and a source and drain electrode 140. The semiconductor layer 116 may be configured with poly-silicon p-Si, and in this case, a predetermined region can be doped with impurities. In addition, the semiconductor layer 116 may be configured with amorphous silicon a-Si, or various organic semiconductor materials such as pentacene. The semiconductor layer 116 may be configured with oxide. When it comes to a material configuring the semiconductor layer 116, the embodiments of the present disclosure are not limited thereto. The semiconductor layer 116 may be an active layer, and is not limited to terms.

The gate electrode 126 may be disposed on the semiconductor layer 116. The gate electrode 126 may be formed of various conductive materials, for example, magnesium (Mg), aluminum (Al), nickel (Ni), chrome (Cr), molybdenum (Mo), tungsten (W), gold (Au), or an alloy thereof, but embodiments of the present disclosure are not limited thereto.

A gate insulation layer 122 may be disposed between the semiconductor layer 116 and the gate electrode 126. The gate insulation layer 122 may be a layer for insulating the semiconductor layer 116 and the gate electrode 126 from each other, and may be formed of an insulating material. For example, the gate insulation layer 122 may be configured as a single-structured layer or a multi-structured layer of silicon oxide (SiOx), or silicon nitride (SiNx), but is not limited thereto.

The source and drain electrode 140 may be electrically connected to the semiconductor layer 116, may be spaced apart from the semiconductor layer 116, and may be configured with copper (Cu), aluminum (Al), molybdenum (Mo), titanium (Ti), or an alloy thereof, but is not limited thereto.

Between the semiconductor layer 116 and the substrate 101, a buffer layer 105, a shielding metal 102, and a first insulation layer 110 may be disposed. The buffer layer 105 may delay dispersion of moisture and/or oxygen permeating the substrate 101. The first insulation layer 110 may protect the semiconductor layer 116, and may block various kinds of defects introduced from the substrate 101. The shielding metal 102 may be disposed between the buffer layer 105 and the first insulation layer 110 so that the shielding metal 102 can protect the second thin film transistor TFT2 from external light or signal interference.

An uppermost layer of the buffer layer 105 contacting the first insulation layer 110 may be formed of a material having a different etch characteristic from that of the remaining layers of the buffer layer 105, the first insulation layer 110, a second insulation layer 120, and a third insulation layer 135. The uppermost layer of the buffer layer 105 contacting the first insulation layer 110 may be formed of one among silicon nitride (SiNx) and silicon oxide (SiOx). The remaining layers of the buffer layer 105, the first insulation layer 110, the second insulation layer 120, and the third insulation layer 135 may be formed of the other one among silicon nitride (SiNx) and silicon oxide (SiOx). For example, the uppermost layer of the buffer layer 105 contacting the first insulation layer 110 may be formed of silicon nitride (SiNx), and the remaining layers of the buffer layer 105, the first insulation layer 110, the second insulation layer 120, and the third insulation layer 135 may be formed of silicon oxide (SiOx), but are not limited thereto.

The first thin film transistor TFT1 may include the semiconductor layer 115, a gate electrode 125, and the source and drain electrode 140. A second insulation layer 120 (a gate insulation layer) may be disposed between the semiconductor layer 115 and the gate electrode 125.

An inter-layer insulation layer 128 may be disposed between the first thin film transistor TFT1 and the second thin film transistor TFT2.

The first thin film transistor TFT1 may include the semiconductor layer 115 disposed on the inter-layer insulation layer 128, the gate electrode 125 overlapping the semiconductor layer 115 with the second insulation layer 120 interposed between the gate electrode 125 and the semiconductor layer 115, and the source and drain electrode 140 disposed on the third insulation layer 135 and contacting the semiconductor layer 115.

The semiconductor layer 115 may be a region in which a channel is formed when the thin film transistor TFT2 is driven. The semiconductor layer 115 may be formed of an oxide semiconductor and may be formed of various organic semiconductors such as amorphous silicon a-Si, polycrystalline silicon poly-Si, or pentacene, but is not limited thereto. The semiconductor layer 115 may be formed on the inter-layer insulation layer 128. The semiconductor layer 115 may have a channel region, a source region, and a drain region. The channel region may be formed such that the channel region is overlapped with the gate electrode 125, with the second insulation layer 120 interposed therebetween to form the channel region between the second insulation layer 120 and the source and drain region. The source region may be electrically connected to the source electrode 140 through the contact hole penetrating the second insulation layer 120 and the third insulation layer 135. The drain region may be electrically connected to the drain electrode 140 through a contact hole penetrating the second insulation layer 120 and the third insulation layer 135.

The gate electrode 125 may be formed on the second insulation layer 120 and may be overlapped with the channel region of the semiconductor layer 115, with the second insulation layer 120 interposed therebetween. The gate electrode 125 may be formed of a first conductive material which is a single-structured layer or a multi-structured layer formed of one among magnesium (Mg), molybdenum (Mo), aluminum (Al), chrome (Cr), gold (Au), titanium (Ti), nickel (Ni), neodymium (Nd), and copper (Cu), or an alloy thereof, but is not limited thereto.

The source electrode 140 may be in contact with the source region of the semiconductor layer 115 exposed through the contact hole penetrating the second insulation layer 120 and the third insulation layer 135. The drain electrode 140 may face the source electrode 140 and may be in contact with the drain region of the semiconductor layer 115 exposed through the contact hole penetrating the second insulation layer 120 and the third insulation layer 135. The source and drain electrode 140 may be formed of a second conductive material which is a single-structured layer or a multi-structured layer formed of one among molybdenum (Mo), aluminum (Al), chrome (Cr), gold (Au), titanium (Ti), nickel (Ni), neodymium (Nd), and copper (Cu), or an alloy of two or more of the above, but is not limited thereto.

Capacitors C1 and C2 may be further disposed on the substrate 101. The capacitors C1 and C2 may be configured to include a first electrode 143, a second electrode 144, and a third electrode 142.

At least one insulation layer may be disposed between the first electrode 143 and the second electrode 144, and at least one insulation layer may be disposed between the second electrode 144 and the third electrode 142. At least one among the first electrode 143, the second electrode 144, and the third electrode 142 may be connected to the source electrode 140 or the drain electrode 140 of the thin film transistor TFT1 and TFT2.

The first capacitor C1 includes the first electrode 143 that is disposed on the same layer as the shielding metal 102 and the second electrode 144. The second capacitor C2 includes the second electrode 144 and the third electrode 142 where the third electrode 142 is disposed on the same layer as the gate electrode 125 of the thin film transistor TFT1.

The connection electrode 155 may be disposed between a first intermediate layer 150 and a second intermediate layer 160. The connection electrode 155 may be connected to the drain electrode 140 by being exposed through a contact hole penetrating a protection layer 145 and the first intermediate layer 150. The connection electrode 155 may be formed of a material having a low resistivity the same as or similar to the drain electrode 140, but is not limited thereto.

The light emitting diode LD which includes a light emitting layer 172 may be disposed on the second intermediate layer 160 and the bank layer 165. The light emitting diode LD may include the anode electrode 171, at least one light emitting layer 172 disposed on the anode electrode 171, and a cathode electrode 173 formed on the light emitting layer 172.

The anode electrode 171 may be electrically connected to the connection electrode 155 disposed on the first intermediate layer 150 through a contact hole penetrating the second intermediate layer 160 and exposed toward an upper side of the second intermediate layer 160.

The anode electrode 171 of each pixel is formed to be exposed by the bank layer 165. The bank layer 165 may be formed of a non-transparent material (for example, black) so as to prevent an optical interference between adjacent pixels. In this case, the bank layer 165 may include a light shielding material formed of at least one among a color pigment, organic black and carbon, but is not limited thereto.

At least one light emitting layer 172 may be formed on the anode electrode 171 in the light emitting region provided by the bank layer 165. The at least one light emitting layer 172 may include a hole transport layer, a hole injection layer, an hole blocking layer, the light emitting layer 172, an electron injection layer, an electron blocking layer, and an electron transport layer on the anode electrode 171, and may be formed by laminating the above mentioned layers in a sequential order or a reverse order according to a light emitting direction. In addition, the light emitting layer 172 may include first and second light emitting stacks facing each other with an electron generation layer interposed therebetween. In such a case, the light emitting layer 172 of one among the first and the second light emitting stacks generates a blue light, and the light emitting layer 172 of the other one there among generates yellow-green light, thereby white light can be generated through the first and the second light emitting stacks. The white light generated by the light emitting stacks enters a color filter positioned on or below the light emitting layer 172, thereby a color image can be implemented. As another example, without a separate color filter, each light emitting layer 172 may implement a color image by generating color light corresponding to each pixel. For example, the light emitting layer 172 of a red pixel may generate red light, the light emitting layer 172 of a green pixel may generate green light, and the light emitting layer 172 of a blue pixel may generate blue light.

The cathode electrode 173 may be formed to face the anode electrode 171 with the light emitting layer 172 interposed between the cathode electrode 173 and the anode electrode 171. The cathode electrode 173 may receive a low potential driving voltage ELVSS.

The encapsulation layer 180 may block moisture from the outside or oxygen from permeating the light emitting diode LD which is vulnerable to the moisture from the outside or oxygen. To this end, the encapsulation layer 180 may have at least one inorganic encapsulation layer, and at least one organic encapsulation layer, but is not limited thereto. Hereinafter, a structure of the encapsulation layer 180 in which the first encapsulation layer 181, the second encapsulation layer 182, and the third encapsulation layer 183 are sequentially laminated is taken as an example.

The first encapsulation layer 181 is formed on the substrate 101 on which the cathode electrode 173 is formed. The third encapsulation layer 183 is formed on the substrate 101 on which the second encapsulation layer 182 is formed, and may be formed to surround an upper surface, a lower surface, and a side surface of the second encapsulation layer 182 together with the first encapsulation layer 181. The first encapsulation layer 181 and the third encapsulation layer 183 may minimize or prevent moisture from the outside or oxygen permeating the light emitting diode LD. The first encapsulation layer 181 and the third encapsulation layer 183 may be formed of an inorganic insulating material with which a low-temperature lamination is possible, such as silicon nitride (SiNx), silicon oxide (SiOx), silicon oxynitride (SiON), or aluminum oxide (Al₂O₃). The first encapsulation layer 181 and the third encapsulation layer 183 are laminated in a low-temperature atmosphere, and thus, may prevent the light emitting diode LD which is vulnerable in a high temperature atmosphere from being damaged during the lamination process.

The second encapsulation layer 182 plays the role of a buffer which alleviates a tension between layers caused by bending of the display device 1 (FIG. 1) and may planarize a stepped portion between layers. On the substrate 101 on which the first encapsulation layer 181 is formed, the second encapsulation layer 182 may be formed of a non-photosensitive organic insulating material such as an acryl resin, an epoxy resin, a phenolic resin, a polyamide resin, a polyimide resin, and polyethylene or silicon oxycarbonate (SiOC), or a photo-sensitive organic insulating material such as photo acryl, but is not limited thereto. When the second encapsulation layer 182 is formed in an ink jet manner, dams DAM1 and DAM2 for preventing the second encapsulation layer 182 in a liquid form from dispersing to an edge of the substrate 101 may be disposed. The dams DAM1 and DAM2 may be disposed closer to the edge of the substrate 101 than the second encapsulation layer 182. Through the dams DAM1 and DAM2, it is possible to prevent dispersion of the second encapsulation layer 182 toward a pad region in which a conductive pad is disposed, which is subjected to position at an outermost side of the substrate 101.

The dams DAM1 and DAM2 are designed for the purpose of preventing dispersion of the second encapsulation layer 182, however, when the second encapsulation layer 182 is formed to excess a height of the dams DAM1 and DAM2 during the process, because the second encapsulation layer 182 which is an organic layer may be exposed to the outside, permeation of the moisture and the like to an inside of the light emitting diode LD can be made easier. Therefore, in order to prevent the permeation, the dams DAM1 and DAM2 may be formed to have at least two or more layers. The dams DAM1 and DAM2 may be provided two or more in number. At this instance, each of the two or more dams DAM1 and DAM2 may be formed in a structure which is the same or different from each other.

The dams DAM1 and DAM2 may be disposed on the inter-layer insulating layer disposed on the third insulation layer 135 in the non-display region NA. The embodiments of the present disclosure are not limited thereto, and the inter-layer insulating layer may be the third insulation layer 135.

The first dam DAM1 may be formed simultaneously with the second intermediate layer 160 and the bank layer 165. When the second intermediate layer 160 is formed, a lower layer of the first dam DAM1 is formed there together and when the bank layer 165 is formed, an upper layer of the first dam DAM1 is formed there together, thereby the first dam DAM1 can be laminated in a dual structure.

In the first dam DAM1, a metal layer formed of the same material as the anode electrode 171 may be disposed between the upper layer and the lower layer, and a metal layer formed of the same material as the source and drain electrode 140 of the thin film transistors TFT1 and TFT2 and a metal layer formed of the same material as the connection electrode 155 may be disposed to be in contact with each other below the lower layer.

The second dam DAM2 may be formed simultaneously with the first intermediate layer 150, the second intermediate layer 160, and the bank layer 165. When the first intermediate layer 150 is formed, a lower layer of the second dam DAM2 is formed there together, when the second intermediate layer 160 is formed, an intermediate layer of the second dam DAM2 is formed there together, and when the bank layer 165 is formed, an upper layer of the second dam DAM2 is formed there together, thereby the second dam DAM2 can be laminated in a triple structure.

In the second dam DAM2, a metal layer formed of the same material as the anode electrode 171 may be disposed between the upper layer and the intermediate layer, a metal layer formed of the same material as the connection electrode 155 may be disposed between the intermediate layer and the lower layer, and a metal layer formed of the same material as the source and drain electrode 140 of the thin film transistor TFT1 and TFT2 may be disposed below the lower layer.

Therefore, the dams DAM1 and DAM2 may be formed of the same material as the first intermediate layer 150, the second intermediate layer 160, and the bank layer 165, but are not limited thereto. In addition, the dams DAM1 and DAM2 may have a structure in which at least one insulation layer including the inter-layer insulation layer 128 is further disposed below the first intermediate layer 150.

The dams DAM1 and DAM2 may overlap a portion of a low potential driving voltage line PL2. For example, the low potential driving voltage line PL2 may be formed on a layer below a region in which the dams DAM1 and DAM2 are disposed in the non-display region NA.

The low potential driving voltage line PL2 and the gate driver 20 configured in the GIP (gate-in-panel) manner are formed in a shape surrounding a periphery of the display panel, and the low potential driving voltage line PL2 may be disposed on an outer side more than the gate driver 20 (FIG. 1), and at least some portion thereof may overlap the gate driver 20. In addition, the low potential driving voltage line PL2 may be connected to the cathode electrode 173 and may apply the low potential driving voltage ELVSS (FIG. 1).

The low potential driving voltage line PL2 may be disposed on the same layer as the connection electrode 155 on the first intermediate layer 150. Alternatively, the low potential driving voltage line PL2 may be disposed on the same layer as the source and drain electrode 140 of the thin film transistor TFT on the third insulation layer 135 or may be disposed on the same layer as the gate electrode 125 of the thin film transistor TFT on the second insulation layer 120. The embodiments of the present disclosure are not limited thereto.

At least one power bus line VL may be disposed between the gate driver 20 and the display region AA. At least one power bus line VL may be disposed on the same layer as the source and drain electrode 140 of the thin film transistor TFT. Of course, the embodiments of the present disclosure are not limited thereto. At least one power bus line VL is simply illustrated on the cross-sectional view, however, a bias voltage line VARL and a reference voltage line VrefL configuring at least one power bus line VL may be disposed parallel to each other on the same layer. Alternatively, the bias voltage line VARL and the reference voltage line VrefL may be disposed in parallel to the other layer or may be disposed to overlap the other layer. At least one power bus line VL is illustrated to be disposed between the gate driver 20 and the display region AA, but the embodiments of the present disclosure are not limited thereto.

A touch layer 190 may be disposed on the encapsulation layer 180. A touch buffer layer 191 may be disposed between a touch sensor metal including touch electrode connection lines 192 and 194 and touch electrodes 195 and 196, and the cathode electrode 173 of the light emitting diode LD in the touch layer 190.

The touch buffer layer 191 may block a liquid chemical (a developing solution or an etching solution) used in the manufacturing process of the touch sensor metal disposed on the touch buffer layer 191 or moisture from the outside from permeating the light emitting layer 172 which includes an organic material. Therefore, the touch buffer layer 191 may prevent damage of the light emitting layer 172 vulnerable to the liquid chemical or the moisture.

The touch buffer layer 191 is formed of an organic insulating material which can be formed at a low temperature below a certain temperature (e.g., 100°C) and has a low dielectric constant of 1 to 3 so as to prevent or at least reduce damage of the light emitting layer 172 which includes an organic material vulnerable to the high temperature. For example, the touch buffer layer 191 may be formed of an acryl-based material, an epoxy-based material or a siloxane-based material. The touch buffer layer 191 formed of the organic insulating material and having a planarization function may prevent damage of the encapsulation layer 180 and a breaking phenomenon of the touch sensor metal formed on the touch buffer layer 191 caused because of bending of the organic electroluminescent display device.

According to the touch sensor structure based on a mutual capacitance, touch electrodes 195 and 196 are disposed on the touch buffer layer 191, and the touch electrodes 195 and 196 may intersect each other.

The touch electrode connection lines 192 and 194 may electrically connect the touch electrodes 195 and 196 to each other. The touch electrode connection lines 192 and 194, and the touch electrodes 195 and 196 may be formed in different layers, with the touch insulation layer 193 interposed therebetween.

The touch electrode connection lines 192 and 194 may overlap the bank layer 165, and thus, may prevent decrease of an opening ratio.

Meanwhile, the touch electrodes 195 and 196 may be electrically connected to a touch driving circuit (not illustrated) through the touch pad part 198 as a portion of the touch electrode connection line 192 passes by an upper portion and a side surface of the encapsulation layer 180 and an upper portion and a side surface of the dams DAM1 and DAM2 and reaches the touch driving circuit (not illustrated). Thus, the touch electrode connection line 192 overlaps the dams DAM1 and DAM2.

The portion of the touch electrode connection line 192 may receive a touch driving signal from the touch driving circuit, deliver the touch driving signal to the touch electrodes 195 and 196, and deliver a touch sensing signal in the touch electrodes 195 and 196 to the touch driving circuit.

The touch electrode connection line 192 may be formed to have a double line structure, and at this instance, each layer of the touch electrode connection line 192 may be formed on the touch buffer layer 191 and the touch insulation layer 193, respectively.

A touch protection layer 197 may be disposed on the touch electrodes 195 and 196. The touch protection layer 197 is disposed only on the touch electrodes 195 and 196 in the drawing, however, is not limited thereto, and the touch protection layer 197 may extend before or after the dams DAM1 and DAM2 to be disposed on the touch electrode connection lines 192 and 194.

A touch pad may be configured by including a first pad layer formed on the same layer and formed of the same material as the gate electrode 126, a second pad layer formed on the same layer and formed of the same material as the source and drain electrode 140, and a third pad layer formed on the same layer and formed of the same material as the touch electrodes 195 and 196 or the touch electrode connection lines 192 and 194.

In addition, a color filter (not illustrated) may be further disposed on the encapsulation layer 180, and the color filter may be disposed on the touch layer 190 or may be disposed between the encapsulation layer 180 and the touch layer 190.

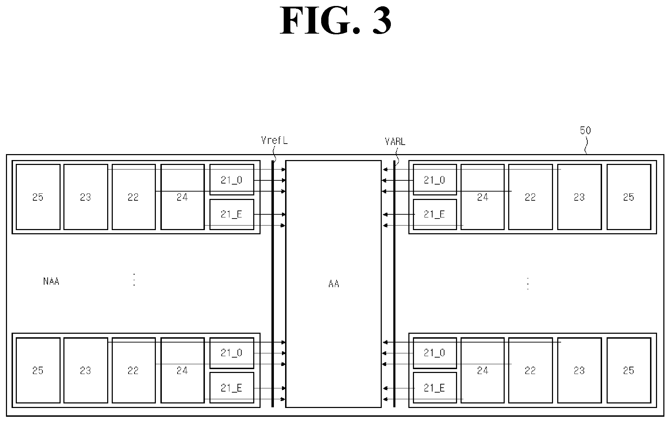

FIG. 3 is a view illustrating a configuration of the gate driver in the display device according to an embodiment of the present disclosure.

Referring to FIG. 3, the display panel 50 may include a display region AA in which an image is displayed, and a non-display region NAA around the display region AA.

In the display region AA, an array of the pixels PX (FIG. 1) is disposed. In the non-display region NAA, at least a portion of the gate driver may be mounted or connected. For example, the gate driver 20 may be disposed on one side or both sides (for example, a left side or a right side) in the non-display region as illustrated. The gate driver 20 disposed on both sides in the non-display region NAA may be configured in a form in which both gate drivers 20 on the right side and the left side are symmetrical to each other (a mirrored form). Hereinafter, the configuration will be described based on the gate driver 20 disposed on the left side of the display region AA.

The gate driver 20 may be formed with first to fifth gate drivers 21 to 25.

The first to third gate drivers 21 to 23 configure a scan driving circuit 20A (FIG. 1), and are configured to output scan signals SC1, SC2, and SC3 (FIG. 7). For example, the first gate driver 21 may be a first scan driver configured to sequentially output a first scan signal SC1 through first scan lines GL1, the second gate driver 22 may be a second scan driver configured to sequentially output a second scan signal SC2 through second scan lines GL2, and the third gate driver 23 may be a third scan driver configured to sequentially output a third scan signal SC3 through third scan lines GL3.

Each of the first to third gate drivers 21 to 23 may be configured as stage circuits dependently connected to each other. Each of the stage circuits is connected to corresponding scan lines GL1, GL2, and GL3, and may output the scan signal SC1, SC2, and SC3 to the scan lines GL1, GL2, and GL3.

The first to third scan signals SC1, SC2, and SC3 may be used to drive at least one transistor provided in the pixel PX. For example, the first to third scan signals SC1, SC2, and SC3 may be used to program the image data DATA (FIG. 1) into the pixel PX, initialize a voltage stored in the pixel PX, or compensate a characteristic of the circuit element.

The fourth and fifth gate drivers 24 and 25 configure the light emission driving circuit 20B (FIG. 1) and are configured to output the light emission signals EM1 and EM2 (FIG. 7). For example, the fourth gate driver 24 may be a first light emission driver configured to output a first light emission signal EM1 through first light emission lines EL1, and the fifth gate driver 25 may be a second light emission driver configured to output a second light emission signal EM2 through second light emission lines EL2. The fourth gate driver 24 may be disposed between the first gate driver 21 and the second gate driver 22. The third gate driver 23 may be disposed between the second gate driver 22 and the fifth gate driver 25.

The first light emission signal EM1 and the second light emission signal EM2 may be used to drive at least one transistor provided in the pixel PX. For example, the first light emission signal EM1 and the second light emission signal EM2 may be used to control light emission of the pixel PX.

Each of the first to fifth gate drivers 21 to 25 is driven by receiving a corresponding start signal and a corresponding clock signal through at least one start signal line and a plurality of clock signal lines. At this instance, each of the clock signals may have a different phase.

The clock signal applied to the first to third gate drivers 21 to 23 may be applied through adjacent clock signal lines, and the clock signal applied to the fourth and fifth gate drivers 24 and 25 may be applied through adjacent clock signal lines. For example, the first to third gate drivers 21 to 23 may receive first and second gate clock signals applied through adjacent clock signal lines, and the fourth and fifth gate drivers 24 and 25 may receive first and second light emission clock signals applied through adjacent clock signal lines. Here, the adjacent clock signal lines may be formed as a pair.

In an embodiment, the first gate driver 21 may be disposed adjacent to the display region AA. That is, the first gate driver 21 may be closest to the display region AA amongst the first to fifth gate drivers. At this instance, the first to third gate drivers 21 to 23 may be disposed sequentially away from the display region AA. In an embodiment, the fifth gate driver 25 may be disposed on an outermost region, and at this instance, the fourth and fifth gate drivers 24 and 25 may be disposed to be sequentially away from the display region AA.

The first to third gate drivers 21 to 23 may be disposed to be adjacent to one among the fourth and fifth gate drivers 24 and 25. For example, the first and second gate drivers 21 and 22 may be disposed to be adjacent to the fourth gate driver 24, and the third gate driver 23 may be disposed to be adjacent to the fifth gate driver 25. In such an embodiment, the fourth gate driver 24 may be disposed between the first and second gate drivers 21 and 22.

In an embodiment, the first gate driver 21 may include an odd-numbered first gate driver 21_O and an even-numbered first gate driver 21_E. At this instance, as illustrated, both the odd-numbered first gate driver 21_O and the even-numbered first gate driver 21_E may be disposed on both sides of the display region AA.

By dividing the first gate driver 21 into the odd-numbered first gate driver 21_O and the even-numbered first gate driver 21_E, it is possible to sufficiently secure time required for application of the data voltage Vdata. In addition, by disposing the odd-numbered first scan driver 21_O and the even-numbered first scan driver 21_E on both sides of the display region AA, it is possible to reduce a deviation of the application time per pixel of the data voltage Vdata. Accordingly, by driving the first gate driver 21, it is possible to sufficiently secure time required for application of the data voltage Vdata, and to reduce a deviation of the application time per pixel, thereby becoming able to improve the image quality of the display panel.

The two or more gate drivers disposed adjacently may receive power by sharing one gate power line. For example, the second gate driver 22 and the fourth gate driver 24 may share one gate power line, and the third gate driver 23 and the fifth gate driver 25 may share one gate power line. However, the present embodiment is not limited thereto.

One or more power bus lines VL may be disposed between the gate driver 20 and the display region AA. The power bus lines VL may include, for example, a bias power line VARL, a reference voltage line VrefL, and the like. Such power bus lines VL may be connected to the pixels PX disposed in the display region AA through a link line (not illustrated) branched off from the power bus line VL, respectively.

In an embodiment, the power bus lines VL may be disposed on both sides of the display region AA in a symmetrical shape. Alternatively, the power bus lines VL may be disposed only on one side among left and right sides or upper and lower sides of the display region AA.

At least some of the power bus line VL and the link line may be formed on the same layer and formed of the same material as the source and drain electrode 140 of the thin film transistor TFT and may be formed on the same layer and formed of the same material as the connection electrode 155. In addition, at least some of the power bus line VL and the link line may be formed on the same layer and formed of the same material as the gate electrodes 125 and 126 or may be formed on the same layer and formed of the same material as the semiconductor layer 115 and 116. In addition, at least some of the power bus line VL and the link line may be formed on the same layer and formed of the same material as the touch electrode connection line 192 and 194 or the touch electrode 195 and 196, or may be formed on the same layer and formed of the same material as the shielding metal 102.

The arrangements of the first to fifth gate drivers 21 to 25 are not limited to what are illustrated. The arrangement of the first to fifth gate drivers 21 to 25 may be variously changed in a possible range so as to reduce a size of the non-display region and a length and a quantity of lines according to the specification of the display panel 50.

In addition, the first gate driver 21 may output the first scan signal SC1 to one pixel row connected to each of the stage circuits, and the second to fifth gate drivers 22 to 25 may commonly output the scan signal to two or more pixel rows connected to each of the stage circuits. That is, as one pixel row is connected to each of the stage circuits in the first gate driver 21, and thus, a delayed output signal is supplied to each row, and as two adjacent pixel rows are connected to one stage circuit in the second to fifth gate drivers 22 to 25, the second to fifth gate drivers 22 to 25 may apply the same output signal in common.

Some of the first to fifth gate drivers 21 to 25 may be implemented as a shift register circuit, and the remaining other may be implemented as an edge trigger circuit. For example, the first gate driver 21 may be implemented as the shift register circuit, and the second to fifth gate drivers 22 to 25 may be implemented as the edge trigger circuit.

Therefore, the first gate driver 21 implemented as the shift register circuit may be connected to the odd-numbered pixel row and the even-numbered pixel row, one by one. In addition, the second to fifth gate drivers 22 to 25 implemented as the edge trigger circuit may be connected to two pixel rows in common.

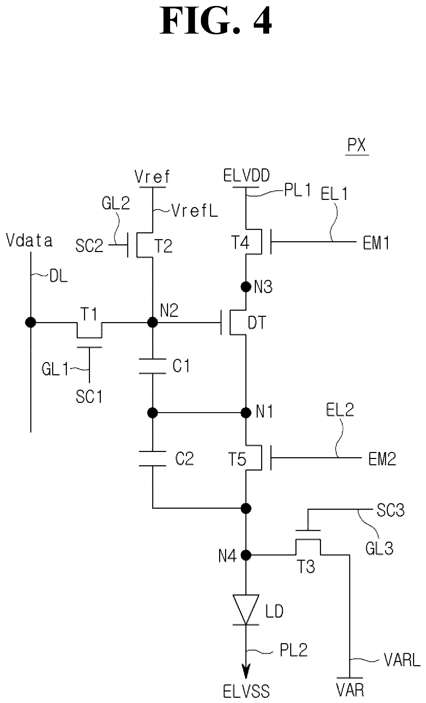

FIG. 4 is a view illustrating the pixel circuit in the display device according to an embodiment of the present disclosure.

Referring to FIG. 4, the pixel PX according to an embodiment may include a driving transistor DT, a light emitting diode LD connected to the driving transistor DT, and a control circuit configured to control an amount of a driving current to be applied to the light emitting diode LD through the driving transistor DT. For example, the control circuit may include a first transistor T1, a second transistor T2, a third transistor T3, a fourth transistor T4, a fifth transistor T5, a first capacitor C1, and a second capacitor C2.

A first electrode of the driving transistor DT is configured to receive a high potential driving voltage ELVDD (connected to a high potential driving voltage line PL1), and a second electrode of the driving transistor DT is connected to a first node N1. A gate electrode of the driving transistor DT is connected to a second node N2. The driving transistor DT may be turned on according to a voltage applied to the second node N2 and may control an amount of the driving current flowing to the light emitting diode LD.

A first electrode of a first transistor T1 is connected to the data line DL and a second electrode of the first transistor T1 is connected to the gate electrode of the driving transistor DT at the second node N2. A gate electrode of the first transistor T1 may be connected to the first scan line GL1 and may receive a first scan signal SC1 via the first scan line GL1. The first transistor T1 may be turned on according to the first scan signal SC1 applied to a first scan line GL1 and may deliver a data voltage Vdata applied to the data line DL to the second node N2. The first transistor T1 may be referred to as a switching transistor.

A first electrode of a second transistor T2 is configured to receive a reference voltage Vref (connected to a reference voltage line VrefL), and a second electrode of the second transistor T2 is connected to the second node N2. A gate electrode of the second transistor T2 may be connected to a second scan line GL2 and may receive a second scan signal SC2 via the second scan line GL2. The second transistor T2 may be turned on according to the second scan signal SC2 applied to the second scan line GL2 and may deliver a reference voltage Vref to the second node N2. The second transistor T2 may be referred to as an initialization transistor.

A first electrode of a third transistor T3 is connected to a bias voltage line VARL and is configured to receive the bias voltage VAR via the bias voltage line VARL, and a second electrode of the third transistor T3 is connected to the anode electrode of the light emitting diode LD at a fourth node N4. A gate electrode of the third transistor T3 may be connected to a third scan line GL3 and may receive a third scan signal SC3 via the third scan line GL3. The third transistor T3 may be turned on according to the third scan signal SC3 applied to the third scan line GL3 and may deliver a bias voltage VAR to the anode electrode of the light emitting diode LD. The third transistor T3 may be referred to as an anode initialization transistor.

A first electrode of the fourth transistor T4 is connected to the high potential driving voltage line PL1 and is configured to receive the high potential driving voltage ELVDD via the high potential driving voltage line PL1 and a second electrode of the fourth transistor T4 is connected to the driving transistor DT at the third node N3. A gate electrode of the fourth transistor T4 may be connected to a first light emission line EL1 and may receive a first light emission signal EM1 via the first light emission line EL1. The fourth transistor T4 may connect the high potential driving voltage line PL1 and the driving transistor DT to each other in response to the first light emission signal EM1 applied to the first light emission line EL1.

A first electrode of a fifth transistor T5 may be connected to the second electrode of the driving transistor DT, the first capacitor C1, and the second capacitor C2 at the first node N1 and a second electrode of the fifth transistor T5 may be connected to the light emitting diode LD, the second capacitor C2, and the second electrode of the third transistor T3 at the fourth node N4. A gate electrode of the fifth transistor T5 may be connected to a second light emission line EL2 and may receive a second light emission signal EM2 via the second light emission line EL2. The fifth transistor T5 may connect the driving transistor DT and the light emitting diode LD to each other in response to the second light emission signal EM2 applied to the second light emission line EL2.

When the fourth transistor T4 and the fifth transistor T5 are turned on, a current path is formed between the high potential driving voltage ELVDD and the low potential driving voltage ELVSS, and a driving current flows to the light emitting diode LD, thereby the light emitting diode LD may emit light. Such fourth transistor T4 and the fifth transistor T5 may be referred to as light emitting transistors.

The first capacitor C1 is connected to the first node N1 and the second node N2. Thus, a first electrode of the first capacitor C1 is connected to the gate electrode of the driving transistor DT, a second electrode of the second transistor T2, and a second electrode of the first transistor T1 at the second node N2 and a second electrode of the first capacitor C1 is connected to a first electrode of the fifth transistor and a first electrode of the second capacitor C2 at the first node N1. The first capacitor C1 may store a voltage corresponding to a voltage difference between the first node N1 and the second node N2. For example, the first capacitor C1 may store a voltage corresponding to a voltage difference between the data voltage Vdata applied to the data line DL and the second node N2, and maintain the stored voltage during one frame, thereby stabilizing a voltage of the gate electrode (that is, the second node N2) of the driving transistor DT. The first capacitor C1 may be referred to as a storage capacitor.

The second capacitor C2 is connected to the first node N1 and the fourth node N4. For example, a first electrode of the second capacitor C2 is connected to the second electrode of the first capacitor C1 and a first electrode of the fifth transistor T5 at the first node N1 and a second electrode of the second capacitor C2 is connected to a second electrode of the fifth transistor, a second electrode of the third transistor T3, and an anode electrode of the light emitting diode LD at the fourth node N4.

The second capacitor C2 may store a voltage corresponding to a voltage difference between the first node N1 and the fourth node N4. In an embodiment, in at least one of the remaining operation periods except a light emission period which will be described below (for example, while the third transistor T3 is turned on), as one end (e.g., the second electrode) of the second capacitor C2 is fixed to a bias voltage VAR, the second capacitor C2 may store a voltage difference according to a change amount of a voltage of the first node N1, thereby compensating a driving characteristic of the driving transistor DT. In addition, both ends (e.g., a first electrode and a second electrode) of the second capacitor C2 are shortcircuited while the light emitting diode LD emits light (e.g., during the light emission period), such that the second capacitor C2 may not have a relationship with the voltage variation of the nodes connected to the driving transistor DT. Thus, the second capacitor C2 may be referred to as a compensation capacitor.

The anode electrode of the light emitting diode LD may be connected to the fourth node N4 and the cathode electrode of the light emitting diode LD may be connected to the low potential driving voltage ELVSS. When the driving transistor DT, the fourth transistor T4, and the fifth transistor T5 are turned on, a current path is formed between the high potential driving voltage ELVDD and the low potential driving voltage ELVSS, and a driving current may flow to the light emitting diode LD. The light emitting diode LD may emit light at luminance corresponding to the driving current applied thereto.

In the embodiment illustrated in FIG. 4, the pixel PX may include an oxide semiconductor thin film transistor. The oxide semiconductor thin film transistor includes a gate electrode, a source electrode, and a drain electrode. The oxide semiconductor thin film transistor has an active layer formed of an oxide semiconductor. Here, the oxide semiconductor may be set as an amorphous oxide semiconductor or a crystalline oxide semiconductor. The oxide semiconductor thin film transistor may be configured as an n-type transistor. The oxide semiconductor thin film transistor may be formed through a low temperature process and has a lower charge mobility than that of the low temperature poly-silicon (LTPS) thin film transistor. Such an oxide semiconductor thin film transistor has an excellent off current characteristic.

In an embodiment, the driving transistor DT may be configured as the oxide semiconductor thin film transistor. In addition, at least one among the transistors T1 to T5 may be configured as the oxide semiconductor thin film transistor.

In addition, in an embodiment, the pixel PX may be a hybrid type which further includes the LTPS (Low Temperature Poly-Silicon) thin film transistor.

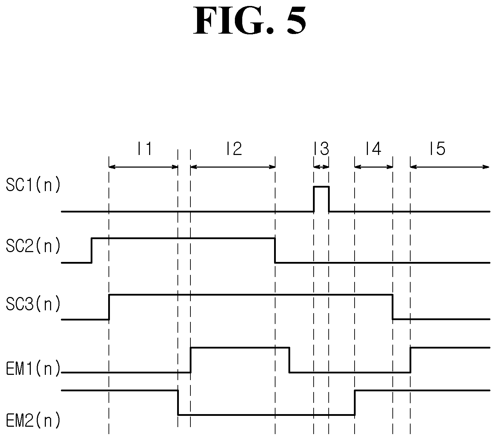

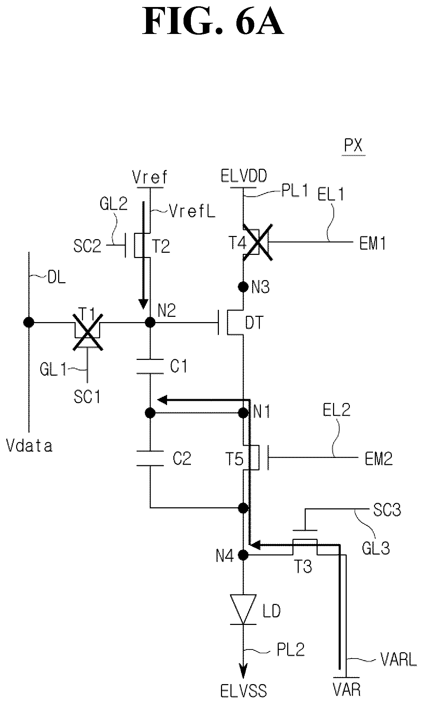

FIG. 5 is an operation timing chart of the pixel circuit in the display device illustrated in FIG. 4, and FIGS. 6A to 6E are diagrams illustrating operations of the pixel circuit in each operation period in greater detail.

Referring to FIG. 5, FIGS. 6A to 6E together, one frame may include an initialization period I1, a sampling period I2, a programming period I3, an anode reset period I4, and a light emission period I5.

During the initialization period I1, the second scan signal SC2 and the third scan signal SC3 in a turn-on level are applied, and the second transistor T2 and the third transistor T3 are turned on. In addition, during the initialization period I1, the second light emission signal EM2 in a turn-on level is applied, and the fifth transistor T5 is turned on.

When the reference voltage Vref is applied to the second node N2 through the second transistor T2 which is turned on, the gate electrode of the driving transistor DT may be initialized to the reference voltage Vref. The reference voltage Vref may be a positive voltage in a low level, and may be a voltage corresponding to black luminance, but is not limited thereto.

When the bias voltage VAR is applied to the fourth node N4 through the third transistor T3 which is turned on, the anode electrode of the light emitting diode LD may be initialized to the bias voltage VAR. The bias voltage VAR may also be applied to the first node N1 through the fifth transistor T5. The bias voltage VAR may be a voltage which is the same as or different from the reference voltage Vref. For example, the bias voltage VAR may be a voltage that is less than the reference voltage Vref, or a negative voltage, but is not limited thereto.

The first capacitor C1 stores a voltage corresponding to a difference between a voltage of the second node N2 and the voltage of the first node N1. That is, during the initialization period I1, the first capacitor C1 may store a voltage Vref-VAR corresponding to a difference between the reference voltage Vref and the bias voltage VAR.

When the fifth transistor T5 is in a turn-on state, both ends of the second capacitor C2 may have the same voltage. That is, during the initialization period I1 in which the fifth transistor T5 is in a turn-on state, both ends of the second capacitor C2 are applied the bias voltage VAR which are the same. Thus, the second capacitor C2 does not store any voltage during the initialization period I1.

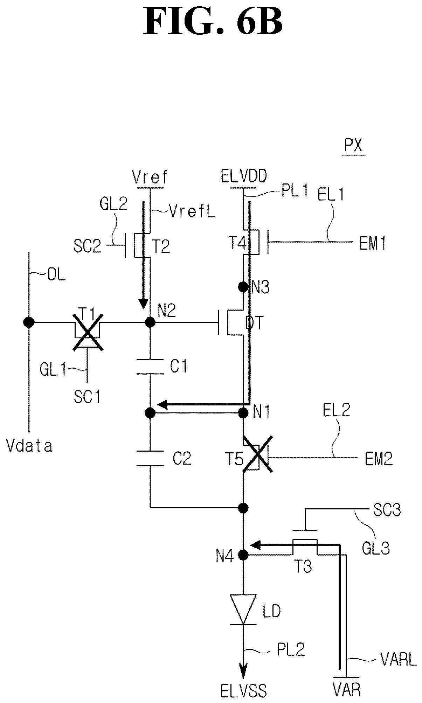

During the sampling period I2 shown in FIG. 6B, the first light emitting signal EM1 may switch over to a turn-on level so that the fourth transistor T4 can be turned on, and the second light emitting signal EM2 may switch over to a turn-off level so that the fifth transistor T5 can be turned off.

When the high potential driving voltage ELVDD is applied to the third node N3 through the fourth transistor T4 which is turned on, the high potential driving voltage ELVDD may be applied to a drain electrode of the driving transistor DT. A reference voltage Vref is applied to the gate electrode of the driving transistor DT through the second transistor T2. A source electrode of the driving transistor DT gets into a voltage variable state.

Accordingly, at the sampling period I2, the driving transistor DT may be turned on and operate in a source follower manner. That is, the driving transistor DT may supply a drain-source current to the first node N1 by the time when a gate-source voltage reaches a threshold voltage Vth of the driving transistor DT. The voltage of the first node N1 may increase gradually from a bias voltage VAR and may converge to a voltage Vref-Vth corresponding to a difference between the reference voltage Vref and the threshold voltage Vth.

The first capacitor C1 stores a voltage corresponding to a difference between the voltage of the second node N2 and the voltage of the first node N1. After the driving transistor DT is saturated, the first capacitor C1 may store a threshold voltage Vth corresponding to a difference between the reference voltage Vref and the voltage Vref-Vth of the first node N1.

The second capacitor C2 stores a voltage corresponding to a difference between a voltage of the first node N1 and a voltage of the fourth node N4. After the driving transistor DT is saturated, the second capacitor C2 may store a voltage Vref-Vth-VAR corresponding to a difference between the voltage Vref-Vth of the first node N1 and the bias voltage VAR.

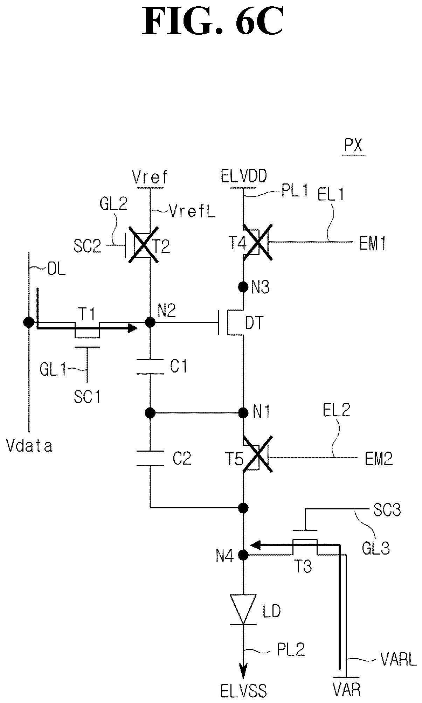

During the programming period I3 shown in FIG. 6C, the second scan signal SC2 switches over to a turn-off level, and the first light emission signal EM1 switches over to a turn-off level, thereby the second transistor T2 and the fourth transistor T4 are turned off, and the third transistor T3 maintains the turn-on state. In addition, during the programming period I3, the first scan signal SC1 is applied in a turn-on level, thereby the first transistor T1 is turned on.

When the data voltage Vdata is applied to the second node N2 through the first transistor T1 which is turned on, the data voltage Vdata may be applied to the second node of the driving transistor DT, which is the gate electrode of the driving transistor DT. At this instance, as the bias voltage VAR is applied to the fourth node N4 through the third transistor T3 which is turned on, one end of the second capacitor C2 may be fixed to the bias voltage VAR which is a direct-current voltage, and the voltage of the first node N1, which is the other end of the second capacitor C2 may be changed by as much as a relationship between a change amount of the voltage of the second node N2 which is changed from the reference voltage Vref to the data voltage Vdata and a voltage stored in the first capacitor C1 and the second capacitor C2. That is, during the programming period I3, the voltage of the first node N1 may be changed according to the change amount of the voltage of the second node N2. If the voltage value stored in the second capacitor C2 is very small, the change amount of the voltage of the first node N1 may be the same as the change amount of the voltage of the second node N2 according to a relational formula.

Therefore, the first capacitor C1 may store the voltage difference between the second node N2 and the first node N1, and the voltage difference between the second node N2 and the first node N1 may be a voltage programmed close to a voltage obtained by compensating the data voltage Vdata by as much as the threshold voltage Vth.

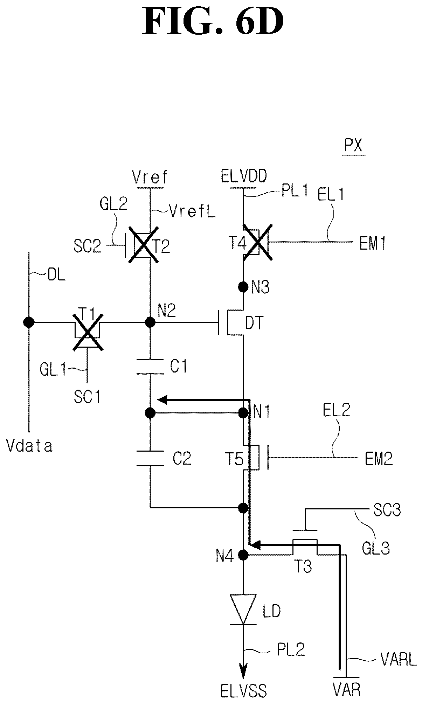

During the anode reset period I4 shown in FIG. 6D, the first light emission signal EM1 may maintain a turn-off level so that the fourth transistor T4 is turned off, and the second light emission signal EM2 in a turn-on level is applied so that the fifth transistor T5 is turned on. The third transistor T3 may maintain a turn-on state, and the anode electrode of the light emitting diode LD may be initialized to the bias voltage VAR.

At the anode reset period I4, the light emitting diode LD does not emit light by the bias voltage VAR applied to the anode electrode of the light emitting diode LD. Instead, by the first capacitor C1, a voltage of the gate electrode of the driving transistor DT may be maintained as a voltage programmed in the previous programming period I3. At this instance, voltages of both ends of the second capacitor C2 are at the same potential state as the bias voltage VAR, and there may be no voltage stored in the second capacitor C2.

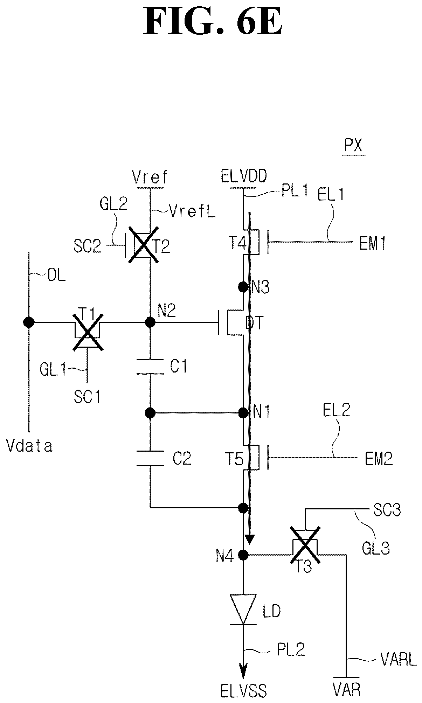

During the light emission period I5 shown in FIG. 6E, the first to third scan signals SC1 to SC3 switch over to a turn-off level, and the first to third transistors T1, T2 and T3 are turned off. In addition, during the light emission period I5, the first light emission signal EM1 and the second light emission signal EM2 in a turn-on level are applied, and the fourth and fifth transistors T4 and T5 are turned on.

Through the fourth and fifth transistors T4 and T5 which are turned on, a current path starting from the high potential driving voltage ELVDD, passing by the driving transistor DT, and reaching the light emitting diode LD is formed. Accordingly, a driving current having a magnitude corresponding to the voltage programmed into the driving transistor DT is provided to the light emitting diode LD, thereby the light emitting diode LD may emit light at luminance corresponding to the driving current.

Here, the voltage programmed into the driving transistor DT is a voltage programmed into the first capacitor C1, and is a voltage compensated for the data voltage Vdata by as much as a threshold voltage Vth. Therefore, deterioration of the driving transistor DT can be compensated.

Meanwhile, during the light emission period I5, when the fifth transistor T5 is turned on, the voltage of the first node N1 may sharply be changed. If the second capacitor C2 having a great electric capacitance is electrically connected to the corresponding nodes and forms a potential difference, a voltage coupling between the first node N1 and the second capacitor C2 may be generated. This interrupts a voltage variation of the first node N1, and a delay may occur until the light emitting diode LD emits light at desired luminance. In addition, when the voltage of the first node N1 is changed by the voltage coupling, a distortion may be generated in the voltage of the second node N2 indirectly connected to the first node N1, and the source-gate voltage of the driving transistor DT cannot be stably maintained.

In the above-described embodiment, during the anode reset period I4 and the light emission period I5, the fifth transistor T5 is turned on, and both ends of the second capacitor C2 are formed to have the same potential, and therefore, the second capacitor C2 does not have a relationship with the voltage of the first node N1 and the fourth node N4 which are the light emitting nodes at the light emission period I5, except holding the threshold voltage Vth at the sampling and programming periods I2 and I3. That is, during the light emission period I5, the voltage coupling between the second capacitor C2 and the first node N1 may be removed or minimized. Therefore, during the light emission period I5, a delay in the light emission, distortion of luminance, or deterioration of the display quality due to the voltage coupling may be prevented.

In addition, in the above-described embodiment, the second capacitor C2 receives the bias voltage VAR through the third transistor T3. That is, at the time of a compensation operation of the second capacitor C2, a voltage of one electrode of the second capacitor C2 may be fixed and stabilized as a direct current voltage through the third transistor T3. In addition, because no additional circuit element (for example, a transistor) and a signal line for supplying a voltage of the second capacitor C2 is required, a size and complexity of a circuit and power consumption may be reduced.

Meanwhile, in the variable refresh rate mode, one frame may be configured with a combination of at least one refresh period RP and at least one skip period SP.

In this case, the refresh period RP may operate as the initialization period I1, the sampling period I2, the programming period I3, and the light emission period I5, and the skip period SP may operate as the anode reset period I4 and the light emission period I5.

During the anode reset period I4 of the skip period SP, the light emitting diode LD does not emit light by the bias voltage VAR applied to the anode electrode of the light emitting diode LD, and the voltage of the gate electrode of the driving transistor DT may be maintained as a voltage programmed in the previous refresh period RP.

In addition, during the skip period SP, since the bias voltage VAR is directly applied to the anode electrode of the light emitting diode LD, the voltage of the anode electrode may be discharged at a relatively fast speed, and a discharge delay of the light emitting diode LD may be improved. Through such anode initialization, a deviation in the integration quantity of the luminance according to the refresh rate may not be generated, and flicker according to a difference in the integration quantity of the luminance may be suppressed.

FIGS. 7A to 7B are respectively a diagram of a pixel circuit in a display device according to another embodiment of the present disclosure and an operation timing chart of the pixel circuit in that display device.

Referring to FIGS. 7A to 7B, in a pixel circuit in FIG. 7A, in comparison with the pixel circuit and the operation timing illustrated in FIGS. 4 to 6E, the fourth transistor T4 receiving the first light emission signal EM1 and the fifth transistor T5 may be configured in an interchanged way, and a voltage level of the first light emission signal EM1 may be opposite.

In other words, in the embodiment in FIGS. 7Ato 7B, the fourth transistor T4 may be configured as the LTPS thin film transistor (P-type transistor). As the fourth transistor T4 is configured as the LTPS thin film transistor having a fast driving characteristic, when the first light emission signal EM1 is applied in a turn-on level, the fourth transistor T4 may be turned on quickly, and the light emission response speed may become fast.

The LTPS thin film transistor includes a gate electrode, a source electrode, and a drain electrode. The LTPS thin film transistor includes an active layer formed of poly silicon. The LTPS thin film transistor may be configured as a p-type thin film transistor. The LTPS thin film transistor has a high electron mobility, and accordingly, has a fast driving characteristic.

When the fourth transistor T4 is the p-type thin film transistor, a turn-on level of the fourth transistor T4 is a low level. Therefore, when the first light emission signal EM1 is applied in a high level, the fourth transistor T4 is turned off. Reversely, when the first light emission signal EM1 is applied in a low level, the fourth transistor T4 is turned on. Therefore, the first light emission signal EM1 may be a gate high voltage VGH at the first period I1, the third period I3, and the fourth period I4 and may be a gate low voltage VGL at the second period I2 and the fifth period I5.

However, the present embodiment is not limited thereto. That is, in various other embodiments, at least some of the first to fifth transistors T1 to T5 of the control circuit except the driving transistor DT may be further configured as the LTPS thin film transistor.

A display device according to embodiments of the present disclosure may be described as below.

One embodiment is a display device, including: a display panel including a display region and a non-display region around the display region, the display region including pixels; a data driver configured to apply a data voltage to the pixels; and (optionally) at least one gate driver configured to apply a scan signal and a light emission signal to the pixels, wherein at least one pixel of the pixels may include: a light emitting diode including an anode electrode, a cathode electrode, and a light emitting layer between the anode electrode and the cathode electrode; a driving transistor having a first electrode connected to a third node, a gate electrode connected to a second node, and a second electrode connected to a first node; a switching transistor having a first electrode connected to a data line and a second electrode connected to the gate electrode of the driving transistor at the second node, the switching transistor having a gate electrode that receives a first scan signal; a first initialization transistor having a first electrode connected to a reference voltage line and a second electrode connected to the second electrode of the switching transistor and the gate electrode of the driving transistor at the second node, the first initialization transistor having a gate electrode that receives a second scan signal; a first light emission transistor having a first electrode connected to a high potential driving voltage line and a second electrode connected to the first electrode of the driving transistor at the third node, the first light emission transistor having a gate electrode that receives a first light emission signal; a second light emission transistor having a first electrode connected to the second electrode of the driving transistor at the first node and a second electrode connected to the anode electrode of the light emitting diode at a fourth node, the second light emission transistor having a gate electrode that receives a second light emission signal; a first capacitor having a first electrode connected to the second electrode of the switching transistor, the second electrode of the first initialization transistor, and the gate electrode of the driving transistor at the second node and a second electrode connected to the second electrode of the driving transistor and the first electrode of the second light emission transistor at the first node; and a second capacitor having a first electrode connected to the second electrode of the first capacitor, the second electrode of the driving transistor, and the first electrode of the second light emission transistor at the first node and a second electrode connected to the second electrode of the second light emission transistor and the anode electrode of the light emitting diode at the fourth node, wherein the driving transistor includes an oxide semiconductor layer.

In the display device according to an embodiment of the present disclosure, the driving transistor, the switching transistor, the first initialization transistor, the first light emission transistor, and the second light emission transistor are n-type transistors.

In the display device according to an embodiment of the present disclosure, the at least one pixel may further include: a second initialization transistor including a first electrode connected to a bias voltage line, a second electrode connected to the anode electrode of the light emitting diode, the second electrode of the second capacitor, and the second electrode of the second light emission transistor at the fourth node, and a gate electrode receiving a third scan signal.

In the display device according to an embodiment of the present disclosure, each of the first capacitor and the second capacitor further includes a third electrode.

In the display device according to an embodiment of the present disclosure, the display device further comprises: a shielding metal that overlaps the driving transistor, wherein the first electrode of at least one of the first capacitor and the second capacitor is on a same layer as the shielding metal, and the third electrode of at least one of the first capacitor and the second capacitor is on a same layer as the gate electrode of the driving transistor.

In the display device according to an embodiment of the present disclosure, the display device further comprises: a shielding metal that overlaps the driving transistor, wherein one of the first and second electrodes of one of the first and second capacitors is on a same layer as the shielding metal, and one of the first and second electrodes of the other one of the first and second capacitors is on a same layer as the gate electrode of the driving transistor.

In the display device according to an embodiment of the present disclosure, the first capacitor may be a storage capacitor and the second capacitor may be a compensation capacitor connected in series with the storage capacitor.

In the display device according to an embodiment of the present disclosure, a portion of the first capacitor and a portion of the second capacitor overlap.

In the display device according to an embodiment of the present disclosure, the second electrode of the second capacitor receives a fixed direct current voltage during a first period and the first electrode and the second electrode of the second capacitor have a same potential during a second period that is different from the first period.

In the display device according to an embodiment of the present disclosure, the pixel is driven during: an initialization period at which a reference voltage supplied by the reference voltage line is applied to the second node by the first initialization transistor while the first initialization transistor is turned on during the initialization period, a sampling period at which the driving transistor operates in a source follower manner, a programming period at which a data voltage supplied by the data line is applied to the gate electrode of the driving transistor at the second node by the switching transistor, and a light emission period at which a driving current is provided to the light emitting diode by the driving transistor.

In the display device according to an embodiment of the present disclosure, the first light emission transistor is a p-type transistor.

In the display device according to an embodiment of the present disclosure, the gate driver may include a plurality of transistors formed through a same process as the first light emission transistor. As a result, the transistors of the gate driver may have a same structure as the first light emission transistor. Additionally, the transistors of the gate driver may be on a same layer as the first light emission transistor.

In the display device according to an embodiment of the present disclosure, in the non-display region, the gate driver may be disposed on both sides of the display region and includes a plurality of scan drivers and a plurality of light emission control drivers, respectively.

In the display device according to an embodiment of the present disclosure, at least one among the plurality of scan drivers may have one pixel row connected to one stage circuit, and each of remaining other scan drivers may have two pixel rows connected to and adjacent to one stage circuit.

In the display device according to an embodiment of the present disclosure, at least one among the plurality of light emission control drivers may apply a same light emission signal to two adjacent pixel rows, the same light emission signal being the first light emission signal or the second light emission signal.

In the display device according to an embodiment of the present disclosure, the display device may further include: a low potential driving voltage line that surrounds a periphery of the display panel in the non-display region.

In the display device according to an embodiment of the present disclosure, the low potential driving voltage line may be disposed on an outer side more than the gate driver.

In the display device according to an embodiment of the present disclosure, the display device may further include: a dam having a portion that overlaps the low potential driving voltage line.

In the display device according to an embodiment of the present disclosure, the display device may further include: a touch electrode connection line that overlaps the dam.

In the display device according to an embodiment of the present disclosure, the touch electrode connection line may be formed in a double wiring structure.

In one embodiment, a pixel of a display device comprises: a light emitting diode including an anode electrode, a cathode electrode, and a light emitting layer between the anode electrode and the cathode electrode; a driving transistor having a first electrode connected to a third node, a gate electrode connected to a second node, and a second electrode connected to a first node; a switching transistor having a first electrode connected to a data line and a second electrode connected to the gate electrode of the driving transistor at the second node, the switching transistor having a gate electrode that receives a first scan signal; a light emission transistor having a first electrode connected to the second electrode of the driving transistor at the first node and a second electrode connected to the anode electrode of the light emitting diode at a fourth node, the light emission transistor having a gate electrode that receives a light emission signal; a first capacitor having a first electrode connected to the second electrode of the switching transistor and the gate electrode of the driving transistor at the second node and a second electrode connected to the second electrode of the driving transistor and the first electrode of the light emission transistor at the first node; and a second capacitor having a first electrode connected to the second electrode of the first capacitor, the second electrode of the driving transistor, and the first electrode of the light emission transistor at the first node and a second electrode connected to the second electrode of the light emission transistor and the anode electrode of the light emitting diode at the fourth node, wherein the pixel is driven during a plurality of periods including a light emission period during which the first electrode and the second electrode of the second capacitor are short circuited while the light emission transistor is turned on during the light emission period, and during at least another one of the plurality of periods the second electrode of the second capacitor is applied a direct current voltage while the light emission transistor is turned off.

In one embodiment, the light emission transistor is a second light emission transistor, and the pixel further comprises: a first initialization transistor having a first electrode connected to a reference voltage line and a second electrode connected to the second electrode of the switching transistor and the gate electrode of the driving transistor at the second node, the first initialization transistor having a gate electrode that receives a second scan signal; a first light emission transistor having a first electrode connected to a high potential driving voltage line and a second electrode connected to the first electrode of the driving transistor at the third node, the first light emission transistor having a gate electrode that receives a first light emission signal; and a second initialization transistor including a first electrode connected to a bias voltage line that supplies the direct current voltage, a second electrode connected to the anode electrode of the light emitting diode, the second electrode of the second capacitor, and the second electrode of the light emission transistor at the fourth node, and a gate electrode receiving a third scan signal.

In one embodiment, the plurality of periods further comprise: an initialization period at which a reference voltage supplied by the reference voltage line is applied to the second node by the first initialization transistor while the first initialization transistor is turned on during the initialization period, and the first electrode and the second electrode of the second capacitor are short circuited while the light emission transistor is turned on during the initialization period; a sampling period at which the driving transistor operates in a source follower manner and the second initialization transistor applies the direct current voltage to the second electrode of the second capacitor while the light emission transistor is turned off during the sampling period; and a programming period at which a data voltage supplied by the data line is applied to the gate electrode of the driving transistor at the second node by the switching transistor, and the second initialization transistor applies the direct current voltage to the second electrode of the second capacitor while the light emission transistor is turned off during the programming period.

In one embodiment, the driving transistor, the switching transistor, the first initialization transistor, the second initialization transistor, the second light emission transistor and the first light emission transistor are n-type transistors.

In one embodiment, the driving transistor, the switching transistor, the first initialization transistor, the second initialization transistor, and the second light emission transistor are n-type transistors, and the first light emission transistor is a p-type transistor.

## Claims

1. A display device (1), comprising:
a display panel (50) including a display region (AA) and a non-display region (NA) around the display region (AA), the display region (AA) including pixels (PX); and
at least one gate driver (20) configured to apply a scan signal and a light emission signal to the pixels (PX),
wherein at least one pixel of the pixels (PX) includes:
a light emitting diode (LD) including an anode electrode (171), a cathode electrode (173), and a light emitting layer (172) between the anode electrode (171) and the cathode electrode (173);
a driving transistor (DT) having a first electrode connected to a third node (N3), a gate electrode connected to a second node (N2), and a second electrode connected to a first node (N1);
a switching transistor (T1) having a first electrode connected to a data line (DL) and a second electrode connected to the gate electrode of the driving transistor (DT) at the second node (N2), the switching transistor (T1) having a gate electrode that receives a first scan signal (SC1);
a first initialization transistor (T2) having a first electrode connected to a reference voltage line (VrefL) and a second electrode connected to the second electrode of the switching transistor (T1) and the gate electrode of the driving transistor (DT) at the second node (N2), the first initialization transistor (T2) having a gate electrode that receives a second scan signal (SC2);
a first light emission transistor (T4) having a first electrode connected to a high potential driving voltage line (PL1) and a second electrode connected to the first electrode of the driving transistor (DT) at the third node (N3), the first light emission transistor (T4) having a gate electrode that receives a first light emission signal (EM1);
a second light emission transistor (T5) having a first electrode connected to the second electrode of the driving transistor (DT) at the first node (N1) and a second electrode connected to the anode electrode (171) of the light emitting diode (LD) at a fourth node (N4), the second light emission transistor (T5) having a gate electrode that receives a second light emission signal (EM2);
a first capacitor (C1) having a first electrode connected to the second electrode of the switching transistor (T1), the second electrode of the first initialization transistor (T2), and the gate electrode of the driving transistor (DT) at the second node (N2) and a second electrode connected to the second electrode of the driving transistor (DT) and the first electrode of the second light emission transistor (T5) at the first node (N1); and
a second capacitor (C2) having a first electrode connected to the second electrode of the first capacitor (C1), the second electrode of the driving transistor (DT), and the first electrode of the second light emission transistor (T5) at the first node (N1) and a second electrode connected to the second electrode of the second light emission transistor (T5) and the anode electrode (171) of the light emitting diode (LD) at the fourth node (N4),
wherein the driving transistor (DT) includes an oxide semiconductor layer.

2. The display device (1) of claim 1, wherein the driving transistor (DT), the switching transistor (T1), the first initialization transistor (T2), the first light emission transistor (T4), and the second light emission transistor (T5) are n-type transistors.

3. The display device (1) of claim 1 or 2, wherein the at least one pixel (PX) further includes:
a second initialization transistor (T3) including a first electrode connected to a bias voltage line (VARL), a second electrode connected to the anode electrode (171) of the light emitting diode (LD), the second electrode of the second capacitor (C2), and the second electrode of the second light emission transistor (T5) at the fourth node (N4), and a gate electrode receiving a third scan signal (SC3).

4. The display device (1) of any of claims 1 to 3, further comprising:
a shielding metal (102) that overlaps the driving transistor (DT, TFT1),
wherein one of the first and second electrodes of one of the first and second capacitors (C1, C2) is on a same layer as the shielding metal (102), and one of the first and second electrodes of the other one of the first and second capacitors (C1, C2) is on a same layer as the gate electrode (125) of the driving transistor (DT, TFT1).

5. The display device (1) of any of claims 1 to 4, wherein the first capacitor (C1) is a storage capacitor and the second capacitor (C2) is a compensation capacitor in series with the storage capacitor.

6. The display device (1) of claim 5, wherein a portion of the first capacitor (C1) and a portion of the second capacitor (C2) overlap.

7. The display device (1) of claim 5 or 6, wherein the second electrode of the second capacitor (C2) receives a fixed direct current voltage (VAR) during a first period (I1) and the first electrode and the second electrode of the second capacitor (C2) have a same potential during a second period (I2) that is different from the first period (I1).

8. The display device (1) of claim 1, wherein the first light emission transistor (T4) is a p-type transistor.

9. The display device (1) of claim 8, wherein the at least one gate driver (20) includes a plurality of transistors that have a same structure as the first light emission transistor (T4).

10. The display device (1) of any of claims 1 to 9, wherein in the non-display region (NA), the at least one gate driver (20) includes a plurality of scan drivers (21, 21, 23), and
wherein, in at least one of the plurality of scan drivers (21, 22, 23), one stage circuit is connected to one pixel row, and in remaining other scan drivers, one stage circuit is connected to two adjacent pixel rows.

11. The display device (1) of any of claims 1 to 10, wherein in the non-display region (NA), the at least one gate driver (20) includes a plurality of light emission control drivers, and
wherein at least one among the plurality of light emission control drivers applies a same light emission signal (EM1) to two adjacent pixel rows, the same light emission signal (EM2) being the first light emission signal or the second light emission signal.

12. The display device (1) of any of claims 1 to 11, further comprising:
a low potential driving voltage (PL2) line that surrounds a periphery of the display panel (50) in the non-display region (NA),
wherein the low potential driving voltage line (PL2) is on an outer side more than the at least one gate driver (20).

13. The display device (1) of claim 12, further comprising:
a dam (DAM1, DAM2) having a portion that overlaps a portion of the low potential driving voltage line (PL2); and
a touch electrode connection line (192, 194) that overlaps the dam (DAM1, DAM2).

14. The display device (1) of claim 13, wherein the touch electrode connection line (192, 194) includes a double wiring structure.

15. The display device of any of claims 1 to 14, further configured such that:
the at least one of the pixels (PX) is driven during a plurality of periods (I1, I2, ..., I5) including a light emission period (I5) during which the first electrode and the second electrode of the second capacitor (C2) are short circuited while the second light emission transistor (T5) is turned on during the light emission period (I5), and during at least another one of the plurality of periods (I1, I2, ..., I5) a direct current voltage (VAR) is applied to the second electrode of the second capacitor (C2) while the light emission transistor (T5) is turned off.
